# EUROPÄISCHE PATENTSCHRIFT

(11) **EP 1 883 165 B1**
(45) Veröffentlichungstag und Bekanntmachung des Hinweises auf die Patenterteilung: **22.03.2017**
(21) Anmeldenummer: 07110680.1
(22) Anmeldetag: 20.06.2007
(51) Int. Cl.: H04B 1/16, H03J 3/20, H04R 25/00, H04B 1/26, H03J 7/02

(54) **Empfangssystem und Verfahren zum Übertragen von Information für eine otologische Vorrichtung**
Receiving system and method for transmitting information for an otological device
Système de réception et procédé destiné à la transmission d'informations pour un dispositif otologique

(30) Priorität: 28.07.2006 DE 102006035102
(43) Veröffentlichungstag der Anmeldung: 30.01.2008
(73) Patentinhaber: Sivantos GmbH, 91058 Erlangen (DE)
(72) Erfinder: Boguslavskij, Mihail, 96450, Coburg (DE); Rückerl, Gottfried, 90461, Nürnberg (DE)
(74) Vertreter: FDST Patentanwälte

(56) Entgegenhaltungen:
- EP-A2- 1 480 492
- DE-B1- 2 744 213
- US-B1- 6 307 427

## Beschreibung

Die Erfindung betrifft ein Empfangssystem für eine otologische Vorrichtung zum Übertragen von Information.

Bei Empfangssystemen zum Übertragen einer Information an eine otologische Vorrichtung, insbesondere an eine Hörhilfe, beispielsweise mittels eines Zubehörteils, insbesondere einer Fernbedienung, einem Programmiergerät oder einer vergleichbaren Vorrichtung, oder von der otologischen Vorrichtung an eine andere otologische Vorrichtung oder ein Zubehörteil, beispielsweise eine Fernbedienung oder eine Programmiervorrichtung, ist ein korrektes Abstimmen einer Resonanzfrequenz eines Schwingungsempfängers des Empfangssystems erforderlich, da eine nicht korrekte Abstimmung der Resonanzfrequenz einen großen Einfluss auf eine Übertragungsqualität oder auf eine erzielbare Übertragungsreichweite hat. Üblicherweise hat ein Frequenzgang eines Empfangssystems eine Bandpasscharakteristik mit einer Mittenfrequenz, wobei die Mittenfrequenz möglichst genau auf einer zum Übertragen vorgesehenen Empfangsfrequenz liegen soll. Eine Empfangsfrequenz eines solchen Empfängers wird im Wesentlichen durch frequenzbestimmende Bauteile wie Spulen, Kondensatoren oder mit diesen verbundenen Bauteilen bestimmt. Solche Bauteile können Toleranzen von einem vorgegebenen Bauteilwert aufweisen, so dass zum Festlegen einer Empfangsfrequenz eine Initialabstimmung erforderlich ist. Darüber hinaus können temperatur- und alterungsbedingte Veränderungen der frequenzbestimmenden Bauteile ein nachträgliches Abstimmen erforderlich machen.

Bei aus dem Stand der Technik bekannten Rundfunkempfängern kann eine Empfangsfrequenz von einem Benutzer manuell abgestimmt werden. Darüber hinaus sind beispielsweise quarzstabilisierte PLL-Empfänger bekannt, welche kein Nachstimmen einer Empfangsfrequenz erfordern (PLL = Phase-Locked-Loop).

Aus der JP10013191A2 ist ein Quadraturmodulationsempfänger bekannt, welcher ausgebildet ist, in Abhängigkeit einer Signalstärke eines Empfangskreises eine Empfangsfrequenz des Empfangskreises zu ändern und somit nachzustimmen.

Aus der Auslegeschrift DE 27 44 213 B1 ist ein Verfahren zur Abstimmung eines innerhalb eines Schaltungsverbundes im Signalweg angeordneten mehrkreisigen Bandfilters und eine Anordnung zur Durchführung des Verfahrens bekannt.

Das Patent US 6307421 B1 betrifft eine Vorrichtung zur Regelung einer Filtercharakteristik, die in der Lage ist, eine charakteristische Frequenz zu regeln. Die Vorrichtung weist einen Signalgenerator zur Erzeugung eines Messsignals, einen Auswahlschalter zur Auswahl eines Signaleingangs, ein Messinstrument zur Erfassung einer Signalantwort des Filters und eine Steuerung zum Vergleichen der Signale auf.

Aus dem Dokument EP 1480492 A2 ist ein Sendespulensystem und eine Fernbedienung für ein Hörhilfsgerät bekannt.

Ein vorab beschriebener PLL-Empfänger kann beispielsweise in Otologischen Vorrichtungen, insbesondere Hörhilfen oder in einem Zubehör für Hörhilfen aufgrund eines Platzbedarfs oder eines Stromverbrauchs nur schwierig oder gar nicht eingesetzt werden.

Der Erfindung liegt somit das Problem zugrunde, eine Empfangsfrequenz eines Empfängers mit möglichst einfachen Mitteln abzustimmen bzw. nachzustimmen.

Dieses Problem wird durch ein Empfangssystem für eine Otologische Vorrichtung gelöst, welches zum Übertragen von Information vorgesehen ist.

Das Empfangssystem kann beispielsweise Bestandteil eines Sende-Empfangssystems, insbesondere eines Transceivers sein.

Das Empfangssystem weist einen Schwingungsempfänger auf, wobei der Schwingungsempfänger ausgebildet ist, ein Trägersignal mit einer Trägerfrequenz zu empfangen. Das Empfangssystem ist ausgebildet, eine Empfangsfrequenz für das Trägersignal zu ändern. Das Empfangssystem weist einen Frequenzregler auf, welcher ausgebildet ist, die Empfangsfrequenz mindestens mittelbar zu erfassen und die Empfangsfrequenz für das Trägersignal auf eine vorgegebene Empfangsfrequenz zu ändern und auf der vorgegebenen Empfangsfrequenz festzustellen.

Der Frequenzregler ist mit dem Schwingungsempfänger mindestens mittelbar verbunden und ausgebildet, ein Anregesignal zu erzeugen und den Schwingungsempfänger mittels des Anregesignals zum Schwingen anzuregen und so eine Antwort-Schwingung mit einer Antwort-Frequenz zu erzeugen. Der Frequenzregler ist weiter ausgebildet, die Empfangsfrequenz in Abhängigkeit der Antwort-Schwingung zu ermitteln.

Auf diese Weise kann vorteilhaft eine Eigenfrequenz eines Empfangssystems beispielsweise eines Schwingkreises eines Empfangssystems, erfasst werden.

In einer nicht beanspruchten Ausführungsform ist das Anregesignal ein im Schwingungsempfänger erzeugtes Rückkopplungssignal. Der Frequenzregler ist in dieser Ausführungsform ausgebildet, den Schwingungsempfänger mindestens mittelbar rückzukoppeln.

Durch ein solches Rückkoppeln wird ein Empfangskreis eines Empfängers angeregt, eine Eigenschwingung mit einer Eigenfrequenz zu erzeugen. Der Frequenzregler kann vorteilhaft die Empfangsfrequenz in Abhängigkeit dieser durch Rückkoppeln erzeugten Eigenfrequenz ermitteln. Die Eigenschwingung bildet somit die Antwort-Schwingung.

In einer nicht beanspruchten Ausführungsform ist der Frequenzregler ausgebildet, die Empfangsfrequenz in Abhängigkeit der Antwort-Frequenz gemäß einer vorbestimmten Zuordnungsvorschrift zu ermitteln. Beispielsweise kann eine vorbestimmte Zuordnungsvorschrift mittels einer abgespeicherten Look-Up-Tabelle verwirklicht sein, wobei einer Mehrzahl von Antwort-Frequenzen jeweils eine Empfangsfrequenz zugeordnet ist.

Dadurch kann vorteilhaft ein Frequenzversatz zwischen einer durch Rückkoppeln erzeugten Eigenfrequenz und einer Empfangsfrequenz berücksichtigt werden.
Der vorab beschriebenen Ausführungsform liegt die Erkenntnis zugrunde, dass zwischen einer durch Rückkoppeln erzeugten Eigenfrequenz und einer Empfangsfrequenz eines Resonanzkreises ein Zusammenhang besteht, welcher beispielsweise durch eine vorbestimmte Zuordnungsvorschrift repräsentiert sein kann. So kann beispielsweise der Frequenzregler die Empfangsfrequenz gemäß einer vorbestimmten Zuordnungsvorschrift in Abhängigkeit der durch Rückkoppeln erzeugten Antwort-Frequenz ermitteln.

In einer bevorzugten Ausführungsform des Empfangssystems ist das Anregesignal ein zeitlich begrenztes Impulssignal oder ein Sprungsignal. Dem liegt die Erkenntnis zugrunde, dass ein Impulssignal als Annäherung an einen Dirac-Deltaimpuls alle Frequenzen im Frequenzintervall von minus unendlich bis plus unendlich enthalten kann und somit einen Empfänger, insbesondere einen Schwingkreis eines Empfängers mit allen Frequenzen anregen kann. In einer bevorzugten Ausführungsform weist das Impulssignal eine Mehrzahl von Frequenzen innerhalb eines Frequenzintervalls auf. Das Impulssignal kann beispielsweise durch ein Signal mit vorbestimmter Bandbreite gebildet sein.

In einer anderen Ausführungsform ist das Anregesignal durch ein Sprungsignal gebildet, wobei das Sprungsignal einen zeitlichen Amplitudenverlauf mit einem zeitabhängigen Amplitudenanstieg aufweist. Der Frequenzgehalt eines solchen Sprungsignals ist abhängig von dem Anstieg des Amplitudenverlaufs.

Ein Anregesignal kann vorteilhaft ein Rauschen repräsentieren, insbesondere ein weißes Rauschen.
Ein weißes Rauschen enthält alle Frequenzen eines Frequenzintervalls jeweils mit gleicher Energie.

Ein Frequenzgehalt eines solchen Anregesignals lässt sich beispielsweise mittels eines Fourier-Transformators erfassen.

In einer bevorzugten Ausführungsform ist das Empfangssystem, insbesondere der Schwingungsempfänger des Empfangssystems, mit einem Schwingungssender zum Übertragen von Information wirkverbunden, wobei der Schwingungssender ausgebildet ist, das Anregesignal zu erzeugen.

In dieser Ausführungsform kann vorteilhaft ein Sender eines Transceivers zum Erzeugen des Anregesignals genutzt werden.

In einer vorteilhaften Ausführungsform sind der Schwingungsempfänger und der Schwingungssender jeweils wenigstens teilweise durch gemeinsame Teile gebildet. Beispielsweise kann ein Resonanzkreis, insbesondere eine Induktivität, insbesondere eine Spule, sowohl als Sendespule als auch als Empfangsspule genutzt werden.

In einer bevorzugten Ausführungsform ist der Frequenzregler ausgebildet, wenigstens einen Zeitabschnitt der Antwort-Schwingung abzutasten und Nulldurchgänge innerhalb des Zeitabschnitts der Antwort-Schwingung zu erfassen und die Antwort-Frequenz der Antwort-Schwingung in Abhängigkeit der erfassten Nulldurchgänge zu ermitteln.

Beispielsweise ist der Frequenzregler ausgebildet, den wenigstens einen Zeitabschnitt der Antwort-Schwingung mit mindestens einem zweifachen der Antwort-Frequenz abzutasten. Weiter bevorzugt ist der Frequenzregler ausgebildet, den wenigstens einen Zeitabschnitt der Antwort-Schwingung mit einem fünffachen oder einem zehnfachen der Antwort-Frequenz abzutasten.

So kann ein Frequenzregler auf einfache Weise eine Antwort-Frequenz erfassen. Der Frequenzregler kann beispielsweise einen Frequenzteiler aufweisen, welcher ausgebildet ist, die Anzahl der erfassten Nulldurchgänge gemäß einem vorbestimmten Teilungsverhältnis zu teilen.

In einer vorteilhaften Ausführungsform ist der Frequenzregler ausgebildet, wenigstens zwei Zeitabschnitte einer Antwort-Schwingung einander zu addieren oder einen erfassten Zeitabschnitt der Antwort-Schwingung zu duplizieren und einen so gebildete Duplikationsergebnis und den erfassten Zeitabschnitt der Antwort-Schwingung einander zu addieren.

Anschließend können die in dem Additionsergebnis enthaltenen Nulldurchgänge erfasst werden.

Auf diese Weise kann der Frequenzregler vorteilhaft ein statistisches Rauschen in einem Antwort-Signal reduzieren.

Dies ist insbesondere dann vorteilhaft, wenn eine Güte eines Empfangssystems, insbesondere eine Güte eines Schwingkreises eines Empfangssystems gering ist und aufgrund der geringen Güte ein zeitliches Ausklingen der Antwort-Schwingung kurz ist.

Die Erfindung betrifft auch ein Verfahren, insbesondere für eine otologische Vorrichtung, zum Empfangen eines Trägersignals mit einer Trägersignalfrequenz und Regeln einer Empfangsfrequenz zum Empfangen des Trägersignals.

Bei dem Verfahren wird die Empfangsfrequenz mindestens mittelbar erfasst und die Empfangsfrequenz, welche zum Empfangen eines Trägersignals vorgesehen ist, auf eine vorgegebene Empfangsfrequenz geändert. Weiter wird ein Anregesignal erzeugt, und mit dem Anregesignal ein Schwingungsempfänger zum Schwingen angeregt. Auf diese Weise wird eine Antwort-Schwingung mit einer Antwort-Frequenz erzeugt. Die Empfangsfrequenz wird in Abhängigkeit der Antwort-Schwingung ermittelt und in einem weiteren Schritt auf die vorgegebene Empfangsfrequenz festgestellt.

Das Anregesignal in dem vorab beschriebenen Verfahren kann in einer anderen Ausführungsform ein zeitlich begrenztes Impulssignal oder ein Sprungsignal sein.

Weitere vorteilhafte Ausführungsvarianten für ein Empfangssystem oder für ein Verfahren ergeben sich aus den in den abhängigen Ansprüchen beschriebenen Merkmalen oder aus einer Kombination der in den abhängigen Ansprüchen beschriebenen Merkmale.

Die Erfindung wird nun anhand von Figuren und weiteren Ausführungsbeispielen beschrieben.
- Figur 1: zeigt ein Ausführungsbeispiel für ein Empfangssystem für eine otologische Vorrichtung, welches ausgebildet ist, eine Empfangsfrequenz mittels eines Anregeimpulses zu erfassen;
- Figur 2: zeigt ein nicht beanspruchtes Ausführungsbeispiel für ein Empfangssystem für eine otologische Vorrichtung, welches ausgebildet ist, eine Empfangsfrequenz mittels eines durch Rückkoppeln erzeugten Anregesignals zu erfassen.

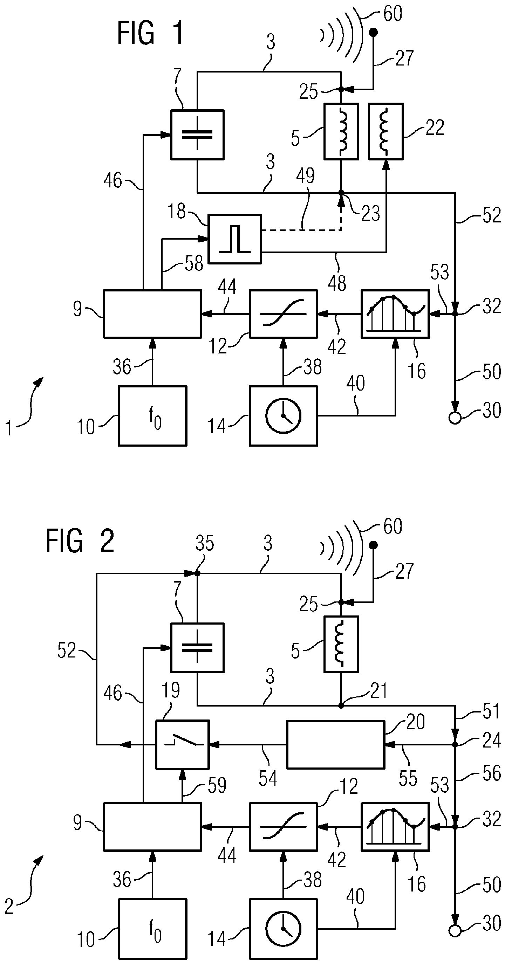

Figur 1 zeigt schematisch ein Ausführungsbeispiel für ein Empfangssystem 1. Das Empfangssystem 1 weist einen Schwingkreis 3 auf. Der Schwingkreis 3 weist eine Induktivität 5 und ein Frequenzstellglied 7 auf.

Das Frequenzstellglied 7 kann beispielsweise durch eine spannungsabhängige Kapazität, insbesondere eine Kapazitätsdiode gebildet sein.

Die Induktivität 5 und das Frequenzstellglied 7 sind jeweils seriell in den Schwingkreis 3 eingebunden.

Das Empfangssystem 1 weist auch einen Regler 9 auf.
Der Regler 9 ist ausgebildet, eingangsseitig eine Antwort-Frequenz zu empfangen und diese mit einer vorgegebenen Frequenz zu vergleichen. Der Regler 9 ist ausgebildet, in Abhängigkeit einer Differenz, gebildet aus der Antwort-Frequenz und der vorgegebenen Empfangsfrequenz ein Steuersignal zum Steuern des Frequenzstellgliedes 7 zu erzeugen und dieses ausgangsseitig auszugeben.

Das Empfangssystem 1 weist auch einen mit dem Schwingkreis 3 wirkverbundenen A/D-Wandler 16 auf, welcher ausgebildet ist, ein eingangsseitig empfangenes Antwort-Signal, welches beispielsweise eine Antwort-Schwingung repräsentiert, abzutasten und ein abgetastetes Signal zu erzeugen und dieses ausgangsseitig auszugeben.

Das Empfangssystem 1 weist auch einen Nulldurchgangszähler 12 auf, welcher ausgebildet ist, in einem eingangsseitig empfangenen abgetasteten Signal Nulldurchgänge zu ermitteln und ein Ausgangssignal zu erzeugen, welches die Anzahl der ermittelten Nulldurchgänge, insbesondere die Anzahl der ermittelten Nulldurchgänge innerhalb eines Zeitintervalls repräsentiert. Das Ausgangssignal des Nulldurchgangszählers 12 kann somit eine Nulldurchgangsfrequenz repräsentieren.

Der A/D-Wandler 16 kann beispielsweise ein 1-Bit-A/D-Wandler sein.

Das Empfangssystem 1 weist auch einen Zeitgeber 14 auf, welcher beispielsweise einen Schwingquarz aufweisen kann. Der Zeitgeber 14 ist ausgangsseitig über eine Verbindungsleitung 38 mit dem Nulldurchgangszähler 12 verbunden und kann so eine Zeitbasis für den Nulldurchgangszähler 12 zur Verfügung stellen. Der Zeitgeber 14 ist auch über eine Verbindungsleitung 40 mit dem A/D-Wandler 16 verbunden und kann so eine Zeitbasis für den A/D-Wandler 16 bilden.

Das Empfangssystem 1 weist auch einen Speicher 10 für eine vorgegebene Empfangsfrequenz auf. Der Regler 9 ist eingangsseitig über eine Verbindungsleitung 36 mit dem Speicher 10 verbunden und ausgebildet, die vorgegebene Empfangsfrequenz aus dem Speicher 10 auszulesen. Der Regler 9 ist ausgangsseitig über eine Verbindungsleitung 46 mit dem Frequenzstellglied 7 verbunden. Der Regler 9 kann das zum Stellen des Frequenzstellgliedes 7 vorgesehene Steuersignal ausgangsseitig über die Verbindungsleitung 46 ausgeben und an das Frequenzstellglied 7 senden.

Der Schwingkreis 3 ist über einen Verbindungsknoten 25 mit einer Antenne 27 verbunden. Die Antenne 27 kann eine Empfangsantenne für ein magnetisches oder ein elektromagnetisches Feld sein. In diesem Ausführungsbeispiel kann die Antenne ein Sendesignal 60 empfangen und dieses über den Verbindungsknoten 25 in den Schwingkreis 3 einspeisen.

Das Sendesignal 60 kann eine Information für eine otologische Vorrichtung, insbesondere eine Hörhilfe oder ein Zubehörteil, beispielsweise eine Fernbedienung repräsentieren. Anders kann das Sendesignal beispielsweise Daten oder einen Datensatz repräsentieren, wobei die Daten oder der Datensatz die Information repräsentiert.

Das Empfangssystem 1 weist auch einen Impulsgenerator 18 auf, welcher ausgebildet ist, in Abhängigkeit eines eingangsseitig empfangenen Steuersignals ein Anregesignal zum Erzeugen einer Antwort-Schwingung zu erzeugen und dieses ausgangsseitig auszugeben. Das Anregesignal ist in dieser Ausführungsform durch einen Rechteckimpuls gebildet.

Der Impulsgenerator 18 ist ausgangsseitig über eine Verbindungsleitung 48 mit einer Anregespule 22 verbunden.

Dazu kann die Anregespule 22 zu der Induktivität 5 derart benachbart angeordnet sein, dass ein durch die Anregespule 22 mittels eines an die Anregespule 22 gesendeten Anregesignals erzeugtes Magnetfeld von der Induktivität 5 empfangen werden kann und dort einen dementsprechenden Strom induzieren kann. Die Anregespule 22 und die Induktivität 5 können miteinander magnetisch gekoppelt sein.

Der Schwingkreis 3 ist über einen Verbindungsknoten 23 und eine Verbindungsleitung 52 mit einem Verbindungsknoten 32 verbunden. Der A/D-Wandler 16 ist über eine Verbindungsleitung 53 mit dem Verbindungsknoten 32 verbunden. Der A/D-Wandler 16 ist somit mit dem Schwingkreis 3 wirkverbunden. Der Verbindungsknoten 32 ist über eine Verbindungsleitung 50 mit einem Ausgang 30 für einen Demodulator verbunden. An dem Ausgang 30 kann beispielsweise ein Demodulator einer otologischen Vorrichtung, insbesondere einer Hörhilfe angeschlossen sein. Anders als der in dieser Figur dargestellte Ausgang 30 kann ein Ausgang für einen Demodulator, insbesondere ein digitaler Demodulator mit dem Ausgang des A/D Wandlers verbunden sein.

Der A/D-Wandler 16 ist ausgangsseitig über eine Verbindungsleitung 42 mit dem Nulldurchgangszähler 12 verbunden. Der Nulldurchgangszähler 12 ist ausgangsseitig über eine Verbindungsleitung 44 mit dem Regler 9 verbunden.

Die Funktionsweise des Empfangssystems 1 wird nun im Folgenden beschrieben:

Der Regler 9 kann zum Ermitteln einer Empfangsfrequenz des Schwingkreises 3 ein zum Erzeugen eines Anregesignals vorgesehenes Steuersignal erzeugen und dieses Steuersignal über die Verbindungsleitung 58 ausgangsseitig an den Impulsgenerator 18 senden.

Der Impulsgenerator 18 kann in Abhängigkeit des eingangsseitig empfangenen Steuersignals ein Anregesignal erzeugen und dieses ausgangsseitig über die Verbindungsleitung 48 an die Anregespule 22 senden. Die Anregespule 22 kann ein dem Anregesignal entsprechendes Magnetfeld erzeugen und dieses in die Induktivität 5 des Schwingkreises 3 einkoppeln und dort eine Antwort-Schwingung erzeugen.

Die somit eingespeiste Energie für die Antwort-Schwingung kann in dem Schwingkreis 3 - durch wechselseitiges Erzeugen von induktiver Energie in der Induktivität 5 und von kapazitiver Energie in dem durch eine spannungsabhängige Kapazität gebildeten Frequenzstellglied 7 - in Abhängigkeit von einer Güte des Schwingkreises 3 aufrechterhalten werden.

Die so erzeugte Antwort-Schwingung wird im folgenden Zeitverlauf in Abhängigkeit der Güte des Schwingkreises 3 exponentiell abklingen.

Ein der Antwort-Schwingung entsprechendes Antwort-Signal kann über den Verbindungsknoten 23, die Verbindungsleitung 52, den Verbindungsknoten 32 und die Verbindungsleitung 53 von dem A/D-Wandler 16 eingangsseitig empfangen werden.

Der A/D-Wandler 16 kann das eingangsseitig empfangene Antwort-Signal abtasten und ein abgetastetes Antwort-Signal über die Verbindungsleitung 42 an den Nulldurchgangszähler 12 senden. Dem A/D-Wandler 16 steht zum Abtasten des Antwort-Signals ein durch den Zeitgeber 14 erzeugtes Zeitsignal zur Verfügung, welches als Zeitbasis dienen kann.

Der Nulldurchgangszähler 12 kann in Abhängigkeit des eingangsseitig empfangenen abgetasteten Antwort-Signals ein Ausgangssignal erzeugen, welches eine Antwort-Frequenz der Antwort-Schwingung repräsentiert.

Die von dem Nulldurchgangszähler 12 erfasste Antwort-Frequenz entspricht in diesem Ausführungsbeispiel dem doppelten der Antwort-Frequenz und somit einer Empfangsfrequenz des Schwingkreises 3, ein sinusförmiges Antwort-Signal vorausgesetzt.

Der Regler 9 kann nun über die Verbindungsleitung 44 das die Antwort-Frequenz repräsentierende Signal eingangsseitig empfangen und eine Differenz aus einer diesem entsprechenden Antwort-Frequenz und einer aus dem Speicher 10 ausgelesenen vorgegebenen Empfangsfrequenz bilden.

Der Regler 9 kann in einem weiteren Schritt in Abhängigkeit der so gebildeten Differenz ein Steuersignal zum Ändern einer Empfangsfrequenz erzeugen und dieses ausgangsseitig über die Verbindungsleitung 46 an das Frequenzstellglied 7 senden. Das Frequenzstellglied 7 kann in Abhängigkeit des eingangsseitig empfangenen Steuersignals eine Empfangsfrequenz des Schwingkreises 3 ändern und auf einem so geänderten Wert feststellen.

Der Regler 9 kann das vorab beschriebene Verfahren beispielsweise so oft wiederholen, bis eine Differenz, gebildet aus der Antwort-Frequenz und der vorgegebenen Frequenz hinreichend klein ist oder die Antwort-Frequenz und die in dem Speicher 10 abgespeicherte vorgegebene Frequenz zueinander identisch sind.

In einer anderen Ausführungsform weist das Empfangssystem 1 keine Anregespule 22 auf. In diesem Ausführungsbeispiel ist der Impulsgenerator 18 ausgangsseitig über eine gestrichelt dargestellte Verbindungsleitung 49 mit dem Verbindungsknoten 23 und somit mit dem Schwingkreis 3 verbunden. Der Impulsgenerator 18 kann auf diese Weise ein Anregesignal unmittelbar in den Schwingkreis 3 einspeisen.

Im Falle einer Ausführungsform mit der Anregespule 22 ist der Schwingkreis 3 vorteilhaft von dem Impulsgenerator 18 galvanisch getrennt.

Denkbar ist auch eine andere Ausführungsform, bei welcher die Verbindungsleitung 52 anstelle einer elektrischen Verbindung mit dem Schwingkreis 3 über den Verbindungsknoten 23 mit der Anregespule 22 verbunden sein kann. Auf diese Weise kann eine Antwort-Schwingung ausgehend von der Induktivität 5 über ein Magnetfeld in die Anregespule 22 eingekoppelt werden und dort mittelbar ein Antwort-Signal erzeugen. Das so mittelbar erzeugte Antwort-Signal kann dem A/D-Wandler 16 über den Verbindungsknoten 32 und die Verbindungsleitung 53 eingangsseitig zur Verfügung stehen.

Figur 2 zeigt schematisch eine nicht beanspruchte Ausführungsform für ein Empfangssystem 2.

Das Empfangssystem 2 weist einen Schwingkreis 3 auf. Der Schwingkreis 3 weist eine Induktivität 5 und ein Frequenzstellglied 7 auf.

Das Frequenzstellglied 7 kann beispielsweise durch eine spannungsabhängige Kapazität, insbesondere eine Kapazitätsdiode gebildet sein.

Die Induktivität 5 und das Frequenzstellglied 7 sind jeweils seriell in den Schwingkreis 3 eingebunden.

Das Empfangssystem 2 weist auch einen Regler 9 auf.
Der Regler 9 ist ausgebildet, eingangsseitig eine Antwort-Frequenz zu empfangen und diese mit einer vorgegebenen Frequenz zu vergleichen. Der Regler 9 ist ausgebildet, in Abhängigkeit einer Differenz, gebildet aus der Antwort-Frequenz und der vorgegebenen Empfangsfrequenz ein Steuersignal zum Steuern des Frequenzstellgliedes 7 zu erzeugen und dieses ausgangsseitig auszugeben.

Das Empfangssystem 2 weist auch einen mit dem Schwingkreis 3 wirkverbundenen A/D-Wandler 16 auf, welcher ausgebildet ist, ein eingangsseitig empfangenes Antwort-Signal, welches beispielsweise eine Antwort-Schwingung repräsentiert, abzutasten und ein abgetastetes Signal zu erzeugen und dieses ausgangsseitig auszugeben.

Das Empfangssystem 2 weist auch einen Nulldurchgangszähler 12 auf, welcher ausgebildet ist, in einem eingangsseitig empfangenen abgetasteten Signal Nulldurchgänge zu ermitteln und ein Ausgangssignal zu erzeugen, welches die Anzahl der ermittelten Nulldurchgänge, insbesondere die Anzahl der ermittelten Nulldurchgänge innerhalb eines Zeitintervalls repräsentiert. Das Ausgangssignal des Nulldurchgangszählers 12 kann somit eine Nulldurchgangsfrequenz repräsentieren.

Der A/D-Wandler 16 kann beispielsweise ein 1-Bit-A/D-Wandler sein.

Das Empfangssystem 2 weist auch einen Zeitgeber 14 auf, welcher beispielsweise einen Schwingquarz aufweisen kann. Der Zeitgeber 14 ist ausgangsseitig über eine Verbindungsleitung 38 mit dem Nulldurchgangszähler 12 verbunden und kann so eine Zeitbasis für den Nulldurchgangszähler 12 zur Verfügung stellen. Der Zeitgeber 14 ist auch über eine Verbindungsleitung 40 mit dem A/D-Wandler 16 verbunden und kann so eine Zeitbasis für den A/D-Wandler 16 bilden.

Das Empfangssystem 2 weist auch einen Speicher 10 für eine vorgegebene Empfangsfrequenz auf. Der Regler 9 ist eingangsseitig über eine Verbindungsleitung 36 mit dem Speicher 10 verbunden und ausgebildet, die vorgegebene Empfangsfrequenz aus dem Speicher 10 auszulesen. Der Regler 9 ist ausgangsseitig über eine Verbindungsleitung 46 mit dem Frequenzstellglied 7 verbunden. Der Regler 9 kann das zum Stellen des Frequenzstellgliedes 7 vorgesehene Steuersignal ausgangsseitig über die Verbindungsleitung 46 ausgeben und an das Frequenzstellglied 7 senden.

Der Schwingkreis 3 ist über einen Verbindungsknoten 25 mit einer Antenne 27 verbunden. Die Antenne 27 kann ein Sendesignal 60 empfangen und dieses über den Verbindungsknoten 25 in den Schwingkreis 3 einspeisen.

Der Schwingkreis 3 des Empfangssystems 2 ist über einen Verbindungsknoten 21 und eine Verbindungsleitung 51 mit einem Verbindungsknoten 24 verbunden. Der Verbindungsknoten 24 ist über eine Verbindungsleitung 56 mit dem Verbindungsknoten 32 verbunden. Der Verbindungsknoten 24 ist auch über eine Verbindungsleitung 55 mit einem Rückkopplungsglied 20 verbunden.

Das Rückkopplungsglied 20 kann beispielsweise durch einen Verstärker gebildet sein. Das Rückkopplungsglied 20 ist ausgangsseitig über eine Verbindungsleitung 54 mit einem Schalter 19, insbesondere einem elektronischen Schalter zum Aktivieren einer Antwort-Schwingung verbunden. Der Schalter 19 ist eingangsseitig mit der Verbindungsleitung 54 und ausgangsseitig über eine Verbindungsleitung 52 und über einen Verbindungsknoten 35 mit dem Schwingkreis 3 verbunden. Der Schalter 19 ist zum Betätigen desselben über eine Verbindungsleitung 59 mit dem Regler 9 verbunden.

Die Funktionsweise des Empfangssystems 2 wird nun im Folgenden beschrieben:

Der Regler 9 kann beispielsweise zum Erfassen einer Empfangsfrequenz des Schwingkreises 3 ein Steuersignal zum Erzeugen einer Antwort-Schwingung erzeugen und dieses ausgangsseitig über die Verbindungsleitung 59 an den Schalter 19 zum Betätigen desselben senden. Der Schalter 19 kann in Abhängigkeit des Steuersignals die Verbindungsleitung 54 und die Verbindungsleitung 52 elektrisch miteinander verbinden.

Auf diese Weise ist der Schwingkreis 3 über den Verbindungsknoten 21, über die Verbindungsleitung 51, weiter über den Verbindungsknoten 24 und die Verbindungsleitung 55, weiter über das Rückkopplungsglied 20, die Verbindungsleitung 54, den geschlossenen Schalter 19, die Verbindungsleitung 52 und schließlich über den Verbindungsknoten 35 mit sich selbst rückgekoppelt. Aufgrund dieser so gebildeten Rückkopplungsschleife kann eine Antwort-Schwingung in Form einer Rückkopplungsschwingung erzeugt werden.

Die so gebildete Antwort-Schwingung weist eine Eigenfrequenz auf, welche zu einer Empfangsfrequenz des Schwingkreises 3 verschieden ist. Die Antwort-Frequenz der Antwort-Schwingung kann über den A/D-Wandler 16, die Verbindungsleitung 42, den Nulldurchgangszähler 12, die Verbindungsleitung 44 - analog zu dem in Figur 1 beschriebenen Empfangssystem 1 - vom Regler 9 eingangsseitig erfasst werden.

Der Regler kann in einem folgenden Schritt in Abhängigkeit einer Differenz, gebildet aus der Antwort-Frequenz und einer in dem Speicher 10 abgespeicherten vorgegebenen Empfangsfrequenz ein Steuersignal zum Stellen des Frequenzstellgliedes 7 erzeugen und dieses ausgangsseitig über die Verbindungsleitung 46 an das Frequenzstellglied 7 senden.

Ein Frequenzversatz, gebildet durch eine Differenz zwischen der Antwort-Frequenz und dem doppelten einer Empfangsfrequenz des Schwingkreises 3 kann beispielsweise durch den Regler 9 berücksichtigt werden, oder bereits dadurch berücksichtigt sein, dass der im Speicher 10 abgespeicherte vorgegebene Frequenzwert einen solchen Frequenzversatz bereits repräsentiert.

Alternativ dazu kann eine Antwort-Frequenz halbiert werden und so - beispielsweise gemäß einer vorbestimmten Zuordnungsvorschrift, insbesondere gemäß einer Look-Up-Tabelle - eine durch ein Erfassen der Nulldurchgänge verursachte Frequenzverdopplung berücksichtigt werden.

## Patentansprüche

1. Empfangssystem (1, 2) für eine otologische Vorrichtung, welches zum Übertragen von Information vorgesehen ist,
wobei das Empfangssystem (1, 2) einen Schwingungsempfänger (3) aufweist, und der Schwingungsempfänger (3) ausgebildet ist, ein Trägersignal mit einer Trägerfrequenz zu empfangen, und wobei das Empfangssystem (1, 2) ausgebildet ist, eine Empfangsfrequenz für das Trägersignal zu ändern,
wobei das Empfangssystem (1, 2) einen Frequenzregler (9, 12, 14, 16) aufweist, welcher ausgebildet ist, die Empfangsfrequenz mindestens mittelbar zu erfassen und die Empfangsfrequenz für das Trägersignal auf eine vorgegebene Empfangsfrequenz zu ändern und auf der vorgegebenen Empfangsfrequenz festzustellen,
**dadurch gekennzeichnet,**
**dass** der Frequenzregler (9, 12, 14, 16) mit dem Schwingungsempfänger (3) mindestens mittelbar verbunden und ausgebildet ist, ein Anregesignal zu erzeugen und den Schwingungsempfänger mittels des Anregesignals zum Schwingen anzuregen und so eine Antwort-Schwingung mit einer Antwort-Frequenz zu erzeugen, und die Empfangsfrequenz in Abhängigkeit der Antwort-Schwingung zu ermitteln,
wobei der Frequenzregler (9, 12, 14, 16) ausgebildet ist, wenigstens einen Zeitabschnitt der Antwort-Schwingung abzutasten und Nulldurchgänge innerhalb des Zeitabschnitts der Antwort-Schwingung zu erfassen,
wobei der Frequenzregler ausgebildet ist, den erfassten Zeitabschnitt der Antwort-Schwingung zu duplizieren und ein so gebildetes Duplikationsergebnis und den erfassten Zeitabschnitt der Antwort-Schwingung einander zu addieren, und die in dem Additionsergebnis enthaltenen Nulldurchgänge zu erfassen, und die Antwort-Frequenz der Antwort-Schwingung in Abhängigkeit der erfassten Nulldurchgänge zu ermitteln
wobei das Anregesignal ein zeitlich begrenztes Impulssignal oder ein Sprungsignal oder ein Rauschsignal ist.

2. Empfangssystem nach Anspruch 1,
**dadurch gekennzeichnet,**
**dass** der Schwingungsempfänger einen Schwingkreis umfassend eine Induktivität und ein Frequenzstellglied aufweist.

3. Empfangssystem nach Anspruch 2,
wobei das Frequenzstellglied durch eine spannungsabhängige Kapazität gebildet ist.

4. Empfangssystem nach einem der Ansprüche 2 oder 3,
**dadurch gekennzeichnet, dass**
der Schwingungsempfänger eine Anregespule und den Schwingkreis umfassend die Induktivität und das Frequenzstellglied aufweist, wobei die Anregespule zu der Induktivität derart benachbart angeordnet ist, dass ein durch die Anregespule mittels eines an die Anregespule gesendeten Anregesignals erzeugtes Magnetfeld in die Induktivität eingekoppelt werden kann und dort die Antwortschwingung erzeugen kann.

5. Empfangssystem nach einem der vorhergehenden Ansprüche,
**dadurch gekennzeichnet, dass**
der Frequenzregler mit der Anregespule (22) verbunden ist und die Antwortschwingung über ein Magnetfeld in die Anregespule eingekoppelt werden kann und so mittelbar ein Antwortsignal erzeugt werden kann.

6. Empfangssystem nach einem der vorhergehenden Ansprüche,
**dadurch gekennzeichnet, dass**
der Frequenzregler ausgebildet ist, den wenigstens einen Zeitabschnitt der Antwort-Schwingung mit mindestens einem zweifachen der Antwort-Frequenz abzutasten.

7. Hörhilfe mit einem Empfangssystem nach einem der vorhergehenden Ansprüche,
wobei die Hörhilfe einen Schwingungssender zum Übertragen von Information aufweist, welcher mit dem Schwingungsempfänger des Empfangssystems wirkverbunden ist und ausgebildet ist, das Anregesignal zu erzeugen.

8. Verfahren für eine otologische Vorrichtung zum Empfangen eines Trägersignals mit einer Trägersignalfrequenz und Regeln einer Empfangsfrequenz zum Empfangen des Trägersignals,
bei welchem
- die Empfangsfrequenz mindestens mittelbar erfasst wird und die Empfangsfrequenz für ein Trägersignal auf eine vorgegebene Empfangsfrequenz geändert wird;
- und die Empfangsfrequenz auf der vorgegebenen Empfangsfrequenz festgestellt wird,
**dadurch gekennzeichnet, dass**
- ein Anregesignal erzeugt wird und mit diesem ein Schwingungsempfänger zum Schwingen angeregt wird und so eine Antwort-Schwingung mit einer Antwort-Frequenz erzeugt wird,
- und die Empfangsfrequenz in Abhängigkeit der Antwort-Schwingung ermittelt wird,
wobei
- das Anregesignal ein zeitlich begrenztes Impulssignal oder ein Sprungsignal oder ein Rauschsignal ist,
wobei wenigstens ein Zeitabschnitt der Antwort-Schwingung abgetastet wird und Nulldurchgänge innerhalb des Zeitabschnitts der Antwort-Schwingung erfasst werden,
und bei dem ein erfasster Zeitabschnitt der Antwort-Schwingung dupliziert wird und ein so gebildetes Duplikationsergebnis und der erfasste Zeitabschnitt der Antwort-Schwingung einander addiert werden und bei dem anschließend die in dem Additionsergebnis enthaltenen Nulldurchgänge erfasst werden, und eine Antwort-Frequenz der Antwort-Schwingung in Abhängigkeit der erfassten Nulldurchgänge ermittelt wird.

## Claims

1. Receiving system (1, 2) for an otological apparatus, which is intended to transmit information, the receiving system (1, 2) having an oscillation receiver (3), and the oscillation receiver (3) being designed to receive a carrier signal at a carrier frequency, and the receiving system (1, 2) being designed to change a receive frequency for the carrier signal,
the receiving system (1, 2) having a frequency regulator (9, 12, 14, 16) which is designed to at least indirectly detect the receive frequency and to change the receive frequency for the carrier signal to a predefined receive frequency and to lock on the predefined receive frequency,
**characterized in that**
the frequency regulator (9, 12, 14, 16) is at least indirectly connected to the oscillation receiver (3) and is designed to generate an excitation signal and to excite the oscillation receiver to oscillate by means of the excitation signal and thus to generate a response oscillation at a response frequency and to determine the receive frequency on the basis of the response oscillation,
the frequency regulator (9, 12, 14, 16) being designed to sample at least one period of the response oscillation and to detect zero crossings inside the period of the response oscillation,
the frequency regulator being designed to duplicate the detected period of the response oscillation and to add a duplication result formed in this manner and the detected period of the response oscillation to one another and to detect the zero crossings contained in the addition result and to determine the response frequency of the response oscillation on the basis of the detected zero crossings,
the excitation signal being a temporally limited pulse signal or a step signal or a noise signal.

2. Receiving system according to Claim 1,
**characterized in that**
the oscillation receiver has a resonant circuit comprising an inductance and a frequency actuator.

3. Receiving system according to Claim 2,
the frequency actuator being formed by a voltage-dependent capacitance.

4. Receiving system according to either of Claims 2 and 3,
**characterized in that**
the oscillation receiver has an excitation coil and the resonant circuit comprising the inductance and the frequency actuator, the excitation coil being arranged adjacent to the inductance in such a manner that a magnetic field generated by the excitation coil by means of an excitation signal transmitted to the excitation coil can be coupled into the inductance and can generate the response oscillation there.

5. Receiving system according to one of the preceding claims,
**characterized in that**
the frequency regulator is connected to the excitation coil (22) and the response oscillation can be coupled into the excitation coil via a magnetic field and a response signal can thus be indirectly generated.

6. Receiving system according to one of the preceding claims,
**characterized in that**
the frequency regulator is designed to sample the at least one period of the response oscillation at at least twice the response frequency.

7. Hearing aid having a receiving system according to one of the preceding claims,
the hearing aid having an oscillation transmitter for transmitting information which is operatively connected to the oscillation receiver of the receiving system and is designed to generate the excitation signal.

8. Method for an otological apparatus for receiving a carrier signal at a carrier signal frequency and regulating a receive frequency for receiving the carrier signal, in which
- the receive frequency is at least indirectly detected and the receive frequency for a carrier signal is changed to a predefined receive frequency;
- and the receive frequency is locked on the predefined receive frequency,
**characterized in that**
- an excitation signal is generated and is used to excite an oscillation receiver to oscillate and a response oscillation at a response frequency is thus generated,
- and the receive frequency is determined on the basis of the response oscillation,
- the excitation signal being a temporally limited pulse signal or a step signal or a noise signal,
at least one period of the response oscillation being sampled and zero crossings inside the period of the response oscillation being detected,
and in which a detected period of the response oscillation is duplicated and a duplication result formed in this manner and the detected period of the response oscillation are added to one another, and in which
the zero crossings contained in the addition result are then detected and a response frequency of the response oscillation is determined on the basis of the detected zero crossings.

## Revendications

1. Système de réception (1, 2) destiné à un dispositif otologique, prévu pour transmettre des informations, dans lequel le système de réception (1, 2) comporte un récepteur d'oscillation (3) et le réception d'oscillation (3) est conçu pour recevoir un signal porteur ayant une fréquence porteuse, et dans lequel le système de réception (1, 2) est conçu pour modifier une fréquence de réception pour le signal porteur,
dans lequel le système de réception (1, 2) comporte un régulateur de fréquence (9, 12, 14, 16) qui est conçu pour détecter au moins indirectement la fréquence de réception et pour modifier la fréquence de réception destinée au signal porteur à une fréquence de réception prédéterminée et pour la fixer à la fréquence de réception prédéterminée,
**caractérisé en ce que** le régulateur de fréquence (9, 12, 14, 16) est au moins indirectement connecté au récepteur d'oscillation (3) et est conçu pour générer un signal d'excitation et pour mettre en oscillation le récepteur d'oscillation au moyen du signal d'excitation et ainsi générer une oscillation de réponse ayant une fréquence de réponse, et pour déterminer la fréquence de réception en fonction de l'oscillation de réponse, dans lequel le régulateur de fréquence (9, 12, 14, 16) est conçu pour balayer au moins une fenêtre temporelle de l'oscillation de réponse et pour détecter des passages à zéro à l'intérieur de la fenêtre temporelle de l'oscillation de réponse,
dans lequel le régulateur de fréquence est conçu pour dupliquer la fenêtre temporelle détectée de l'oscillation de réponse et pour additionner l'un à l'autre un résultat de la duplication ainsi constitué et la fenêtre temporelle détectée de l'oscillation de réponse, pour détecter les passages à zéro obtenus dans le résultat de l'addition, et pour déterminer la fréquence de réponse de l'oscillation de réponse en fonction des passages à zéro déterminés, dans lequel le signal d'excitation est un signal impulsionnel ou un signal échelonné ou un signal de bruit limité dans le temps.

2. Système de réception selon la revendication 1, **caractérisé en ce que** le récepteur d'oscillation comporte un circuit oscillant comprenant une inductance et un élément de réglage de fréquence.

3. Système de réception selon la revendication 2, dans lequel l'élément de réglage de fréquence est constitué par une capacité dépendant de la tension.

4. Système de réception selon l'une quelconque des revendications 2 ou 3,
**caractérisé en ce que** le récepteur d'oscillation comporte une bobine d'excitation et le circuit oscillant comprenant l'inductance et l'élément de réglage de fréquence, dans lequel la bobine d'excitation est disposée au voisinage de l'inductance de manière à ce qu'un champ magnétique généré par la bobine d'excitation au moyen d'un signal d'excitation émis vers la bobine d'excitation puisse être injecté dans l'inductance et y générer l'oscillation de réponse.

5. Système de réception selon l'une quelconque des revendications précédentes,
**caractérisé en ce que** le régulateur de fréquence est connecté à la bobine d'excitation (22) et **en ce que** l'oscillation de réponse peut être injectée par l'intermédiaire d'un champ magnétique dans la bobine d'excitation et à ce qu'un signal de réponse peut ainsi être généré indirectement.

6. Système de réception selon l'une quelconque des revendications précédentes,
**caractérisé en ce que** le régulateur de fréquence est conçu pour balayer l'au moins une fenêtre temporelle de l'oscillation de réponse à au moins deux fois la fréquence de réponse.

7. Appareil auditif comportant un système de réception selon l'une quelconque des revendications précédentes,
dans lequel l'appareil auditif comporte un émetteur d'oscillation destiné à transmettre des informations, qui est relié de manière fonctionnelle au récepteur d'oscillation du système de réception et est conçu pour générer le signal d'excitation.

8. Procédé destiné à un dispositif otologique pour recevoir un signal porteur ayant une fréquence de signal porteur et réguler une fréquence de réception pour recevoir le signal porteur,
dans lequel
- la fréquence de réception est détectée au moins indirectement et la fréquence de réception est modifiée pour un signal porteur à une fréquence de réception prédéterminée ;
- et la fréquence de réception est fixée à la fréquence de réception prédéterminée,
**caractérisé**
- **en ce qu'**un signal d'excitation est généré, en ce qu'un récepteur d'oscillation est mis en oscillation par celui-ci et en ce qu'une oscillation de réponse ayant une fréquence de réponse est ainsi générée,
- et **en ce que** la fréquence de réception est déterminée en fonction de l'oscillation de réponse,
dans lequel
- le signal d'excitation est un signal impulsionnel ou un signal échelonné ou un signal de bruit limité dans le temps,
dans lequel au moins une fenêtre temporelle de l'oscillation de réponse est balayée et des passages à zéro sont détectés à l'intérieur de la fenêtre temporelle de l'oscillation de réponse,
et dans lequel une fenêtre temporelle détectée de l'oscillation de réponse est dupliquée et un résultat de duplication ainsi constitué et la fenêtre temporelle détectée de l'oscillation de réponse sont additionnés l'un à l'autre, et dans lequel les passages à zéro contenus dans le résultat de l'addition sont ensuite détectés, et une fréquence de réponse de l'oscillation de réponse est déterminée en fonction des passages à zéro détectés.
